Europäisches Patentamt

European Patent Office

Office européen des brevets

(11) Veröffentlichungsnummer: **0 338 206**

**A1**

## EUROPÄISCHE PATENTANMELDUNG

(21) Anmeldenummer: 89102913.4

(51) Int. Cl.⁴: **H01L 21/285**

(22) Anmeldetag: 20.02.89

(30) Priorität: 24.03.88 DE 3810025
18.08.88 DE 3828126

(43) Veröffentlichungstag der Anmeldung:
25.10.89 Patentblatt 89/43

(84) Benannte Vertragsstaaten:
AT BE CH DE FR GB IT LI LU NL SE

(71) Anmelder: Siemens Aktiengesellschaft
Wittelsbacherplatz 2
D-8000 München 2(DE)

(72) Erfinder: Hieber, Konrad, Dr.
Am Herrenholz 10
D-8011 Neukeferloh(DE)
Erfinder: von Tomkewitsch, Jasper
Friedrich-Ebert-Strasse 4
D-8012 Ottobrunn(DE)
Erfinder: Treichel, Helmuth
Weldishofer Strasse 4
D-8900 Augsburg(DE)
Erfinder: Kruck, Thomas
Am Wachberg 9
D-5042 Erfstadt(DE)
Erfinder: Spindler, Oswald, Dr.
Lortzingstrasse 16
D-8011 Vaterstetten(DE)

(54) Verfahren zum konformen Abscheiden von Wolfram auf Halbleitersubstrate bei der Herstellung von höchstintegrierten Schaltungen.

(57) Bei einem Verfahren zum konformen Abscheiden von Wolfram auf Halbleitersubstrate aus flüchtigen Wolframhalogenphosphanverbindungen, insbesondere beim Auffüllen von Kontaktlöchern in Isolationsschichten, wird die aus Wolfram bestehende ganzflächig auf dem Halbleitersubstrat abgeschiedene Metallschicht dadurch erzeugt, daß die festen Trihalogenphosphan-Wolframkomplexverbindungen bei Temperaturen unter 200° C verdampft und entweder thermisch bei Temperaturen unter 450° C, oder durch Plasmaaktivierung oder laserinduziert zersetzt werden. Als Komplexe werden verwendet $W(PF_3)_6$, $W(PCl_3)_6$, $W(PF_3)_5L$ wie zum Beispiel $W(PF_3)_5N_2$, $W(PF_3)_4(\eta^4\text{-L})$ wie zum Beispiel $W(PF_3)_4$-1.5 Cyclooctadien oder $W(PF_3)_3(\eta^6\text{-L})$ wie zum Beispiel $W(PF_3)_3 C_6H_6$. Das Verfahren erlaubt Kontaktlöcher, auch via holes, mit hohem Aspektverhältnis lunkerfrei mit Wolfram zu füllen und wird verwendet zur Herstellung von Mehrlagenverdrahtungen von höchstintegrierten Halbleiterschaltungen.

## Verfahren zum konformen Abscheiden von Wolfram auf Halbleitersubstrate bei der Herstellung von höchstintegrierten Schaltungen.

Die Erfindung betrifft ein Verfahren zum konformen Abscheiden von Wolfram auf Halbleitersubstrate, insbesondere beim Auffüllen von in Isolationsschichten geätzten Kontaktlöchern, wie es zur Herstellung von höchstintegrierten Halbleiterschaltungen zur Ausbildung von elektrischen Leitbahnen auf mit Halbleiterstrukturen versehenen Substraten erforderlich ist, durch Zersetzung aus der Gasphase unter Verwendung von Wolframhalogenphosphanverbindungen.

Ein solches Verfahren ist beispielsweise aus der DE-OS 1 900 119 bekannt. Dabei werden Wolframtrifluorphosphanverbindungen und dessen Hydride bei Temperaturen von 350 bis 600°C und vermindertem Druck zersetzt und auf Halbleitersubstrate als Kontaktmetallschichten ganzflächig niedergeschlagen.

Ein weiteres Verfahren, in welchem Wolfram durch thermische Zersetzung von Wolframhexafluorid ganzflächig als Metallschicht erzeugt und durch Rückätzen als Kontaktlochfüller (sogenannte plugs) benutzt wird, ist in der europäischen Patentanmeldung 87 104 441.8 vorgeschlagen worden.

Bei der fortschreitenden Miniaturisierung von Halbleiterbauelementen treten bereits Strukturen im Bereich von 1 $\mu$m und darunter auf. Um die sehr kleinen aktiven Bereiche auf dem Halbleitersubstrat elektrisch ansteuern zu können, müssen diese mit metallischen Leitbahnen verbunden werden. Damit dieser Kontakt nur an definierten Stellen stattfindet, sind die Leitbahnebenen durch eine Isolationsschicht, zum Beispiel aus $SiO_2$ bestehend, vom Halbleitersubstrat getrennt. Die Verbindung zu den aktiven Bereichen des Halbleitersubstrats findet über Kontaktlöcher statt, die in die Isolationsschicht eingeätzt werden. Analoge Verhältnisse herrschen auch bei höchstintegrierten Bauelementen, wo zwei und mehr Leitbahnen für die elektrische Versorgung der sehr dicht gepackten aktiven Bereiche notwendig sind. Auch in diesem Fall muß ein elektrischer Kontakt durch sehr kleine Löcher (sogenannte via holes) zwischen den verschiedenen Leitbahnebenen hergestellt werden.

Da aufgrund von schaltungstechnischen Überlegungen, zum Beispiel parasitäre Kapazitäten, die Isolationsschicht eine Mindestdicke von 0,7 bis 1,5 $\mu$m besitzen muß, treten bei den Kontaktlöchern bzw. via holes Tiefen/Durchmesser-Verhältnisse von größer 1 auf. Bei diesen sehr kleinen und tiefen Kontaktlöchern nimmt die Schichtdicke an den Flanken des Kontaktloches sehr stark ab (55 bis 80 Prozent Abnahme), wenn das Leitbahnmaterial, zum Beispiel Aluminiumlegierungen (Aluminium-Silizium), wie bisher üblich durch Kathodenzerstäuben (sogenanntes Sputtern) aufgebracht wird. Da die Leitbahnen mit extrem hohen Stromdichten belastet sind, zum Beispiel 1 x 10^6 A/cm², bewirkt jede Querschnittsverengung einen lokalen Temperaturanstieg, der zum Durchbrennen der Leitbahn führen kann, oder zumindest einen unerwünschten Materialtransport, sowie Diffusion oder Reaktion an Grenzflächen, beschleunigt.

Ein weiteres Problem besteht darin, daß sich in den Kontaktlöchern durch die geringere Beschichtungsrate an den vertikalen Flanken Hohlräume ausbilden (schlechte Konformität). Wird nun anschließend eine Isolationsschicht, zum Beispiel als Unterlage für die zweite Aluminium-Silizium Leitbahnebene abgeschieden, so ist es praktisch nicht möglich, den im Kontaktloch befindlichen Hohlraum vollständig aufzufüllen. Da sich bei weiteren Fertigungsschritten in diesem Hohlraum zum Teil reaktive oder korrosive Medien ansammeln können, sind für zuverlässige Bauelemente Metallisierungsverfahren für Kontaktlöcher bzw. via holes notwendig, bei denen eine vollständige Auffüllung stattfindet.

Derzeit werden Abscheideverfahren aus der Gasphase, sogenannte CVC (= chemical vapor deposition)-Verfahren in der Halbleitertechnik zum Auffüllen von Kontaktlöchern eingesetzt, die sich durch eine sehr gute Kantenbedeckung (Konformität) auszeichnen. Dabei kann man zwei verschiedene Methoden unterscheiden:

1. Die selektive Abscheidung der Metallisierungsschicht in Kontaktlöchern unter Verwendung von Wolfram oder Tantalsilizid als Kontaktlochfüller, wie zum Beispiel aus einem Aufsatz von E. K. Broadbent et. al. in J. Electrochem. Soc., Solid State Sci. and Technol. (1984), Seiten 1427 bis 1433 oder aus der europäischen Patentanmeldung 0 090 319 bekannt ist:

Bei dieser Methode des CVD-Verfahrens wird der Beschichtungsprozeß derart eingestellt, daß die chemische Reaktion, die die Beschichtung bewirkt, durch eine Reaktion mit einem bestimmten Substratmaterial, zum Beispiel mit Silizium oder einer Siliziumlegierung, lokal ausgelöst werden kann. Es kann somit erreicht werden, daß das Kontaktloch vollständig mit "Metall" aufgefüllt wird. Wolfram kann bei Temperaturen um 360°C bis zu 1 $\mu$m Schichtdicke selektiv auf Silizium bzw. einer Siliziumlegierung abgeschieden werden. Aufgrund der die Selektivität auslösenden Reaktion

$$2\ WF_6 + 3\ Si \rightarrow 3\ SiF_4 + 2\ W$$

wird jedoch Silizium geätzt ($SiF_4$ besitzt einen hohen Dampfdruck), was zu Kurzschlüssen zwischen dem Dotierungsgebiet und dem Substrat führen kann. Das größte Problem bei einer selektiven Abscheidung besteht jedoch darin, die natürliche Oxidhaut in situ auf dem zu beschichtenden Silizium bzw. der Siliziumlegierung zu entfernen. Diese Maßnahme ist unbedingt erforderlich, um bei der Beschichtung eine ausreichende Selektivität gegenüber der $SiO_2$-Isolationsschicht zu erreichen. Bei der selektiven Wolfram-Abscheidung bewirkt das $WF_6$ bereits die Ätzung der natürlichen Oxidhaut (ca. 3 nm Dicke). Jedoch ist dieser Ätzschritt, der eine Nebenerscheinung des Beschichtungsprozesses darstellt, nur schwer zu steuern.

Die selektive Tantalsilizid-Abscheidung mit Tantalpenta chlorid als Metallausgangsverbindung, wie in der europäischen Patentanmeldung 0 090 319 beschrieben, bietet die Möglichkeit, vor des Beschichtung in situ einen eigenen Ätzschritt durchzuführen. Aber auch hier zeigt sich, daß ein definiertes Ätzen der natürlichen Oxidhaut (zum Beispiel mit Fluorwasserstoff) sehr schwierig ist. Vor allem gibt es keine Möglichkeit der Endpunktkontrolle, da die natürliche Oxidhaut sehr dünn ist und die Summe aller Kontaktlochflächen sehr klein ist im Vergleich zur $SiO_2$-Isolationsschichtfläche.

2. Die ganzflächige Abscheidung der Metallisierungsschicht auf der Isolationsschicht, einschließlich der Kontaktlöcher, unter Verwendung von Wolfram, wie aus einem Aufsatz von L. Brors et. al. aus Solid State Technol. April (1984), Seiten 313 bis 314, bekannt ist: Aufgrund der guten Kantenbedeckung des CVD-Verfahrens wächst die Schicht im Kontaktloch von allen Seiten etwa gleich schnell und füllt somit das Kontaktloch auf, wobei im Zentrum des Kontaktloches ein sehr schmaler Kanal (zum Beispiel 0,2 $\mu$m Durchmesser) offenbleibt. Dieser Zustand ist bei einer Schichtdicke, gemessen auf horizontaler Struktur, die etwas mehr als der Hälfte des Kontaktlochdurchmessers entspricht, eingetreten. Ätzt man nun die Metallschicht wieder ganzflächig ab, so kann erreicht werden, daß das Metall von der Isolationsschicht vollständig entfernt ist, während das Kontaktloch noch mit Metall gefüllt bleibt. Die Gefahr bei diesem Verfahren besteht darin, daß aufgrund von Schichtdickenschwankungen - verursacht durch lokale Temperatur- und Konzentrationsschwankungen der Reaktionsgase auf der Siliziumscheibe - während des Beschichtens nicht alle Kontaktlöcher optimal aufgefüllt werden, das heißt, es gibt auf einer Siliziumscheibe auch Kontaktlöcher, bei denen der verbleibende Kanal im Zentrum einen Durchmesser von größer 0,2 $\mu$m besitzt. Beim anschließenden ganzflächigen Rückätzen der Wolframschicht werden nun diese Kanäle mit größerem Durchmesser wieder aufgeweitet, so daß unter Umständen nur noch sehr wenig Wolfram im Kontaktloch verbleibt oder sogar das Silizium des Substratmaterials angegriffen wird. Diese Gefahr ist besonders bei der mit Silan ($SiH_4$) aktivierten Wolfram-Abscheidung

gegeben (Abscheiderate bei 450 °C ca. 65 nm/min), da hier Konzentrationsschwankungen im Reaktionsgemisch einen besonders hohen Einfluß auf die Beschichtungsrate haben.

Eine sichere Lösung bietet nur ein relativ aufwendiges Verfahren, bei dem die Kontaktlöcher nicht vollständig mit Wolfram gefüllt werden (zum Beispiel minimaler Durchmesser des verbleibenden Kanals 0,3 $\mu$m) und die offenen zentralen Kanäle mit einer gut verfließenden Lackschicht gefüllt werden, wie es in der eingangs erwähnten europäischen Patentanmeldung 87 104 441.8 vorgeschlagen wird. Nach dem ganzflächigen Rückätzen der Wolframschicht muß in einem weiteren Ätzschritt (Sauerstoffplasma) der Lackstöpsel aus dem zentralen Kanal entfernt werden. Erst dann kann mit Standardverfahren die Aluminium-Legierungsschicht aufgebracht werden.

Die weitere Möglichkeit, Wolfram ohne Silanzusatz nur durch Wasserstoffreduktion des Wolframhexafluorid abzuscheiden, liefert zwar eine bessere Auffüllung der zentralen Kanäle, die Abscheiderate sinkt bei 450 °C auf zum Beispiel 20 nm/min, jedoch mindestens um den Faktor 3, so daß dieses Verfahren für eine Fertigung sehr teuer wird, da mehrere Anlagen notwendig sind, um einen Durchsatz von zum Beispiel 40 Scheiben pro Stunde zu garantieren.

Das Problem bei den bisher bekannten Verfahren zur Abscheidung von Wolframschichten, die für die Mikroelektronik geeignet sind, besteht darin, daß mindestens zwei Reaktionspartner, zum Beispiel Wolframhexafluorid und Wasserstoff, für die Metallabscheidung notwendig sind, die in einer bestimmten Konzentration in die sehr kleinen Kontaktlöcher eingebracht werden müssen.

Die Aufgabe, die der Erfindung zugrundeliegt, besteht nun darin, ein Verfahren zur konformen Wolfram-Abscheidung, insbesondere zum Kontaktlochfüllen mit Wolfram anzugeben, welches

1. eine hohe Gleichmäßigkeit (Schichtdickenschwankungen kleiner 3 Prozent auf 150 mm Siliziumscheiben) aufweist,

2. eine Aufwachsrate größer 0,3 $\mu$m/min gewährleistet, damit der Prozeß auch in Einzelscheibenanlagen und "small batch"-Anlagen (für 150 mm Siliziumscheiben) einen fertigungsgerechten Durchsatz von mindestens 15 Siliziumscheiben/Stunde und Reaktionskammer liefert und

3. mit Ausgangsverbindungen arbeitet, die weniger korrosiv und giftig sind als Wolframhexafluorid.

Diese Aufgabe wird bei dem eingangs erwähnten Verfahren erfindungsgemäß dadurch gelöst, daß als Ausgangsverbindungen für die Zersetzung feste, flüchtige Wolframhalogenphosphanverbindungen verwendet werden, und daß die Zersetzung thermisch bei Temperaturen unter 450° C, durch Plasmaaktivierung, oder laserinduziert durchgeführt wird.

Dabei liegt es im Rahmen der Erfindung, daß folgende flüchtige Wolfram-Komplexverbindungen verwendet werden:

$W(PF_3)_6$ = Hexakis(trifluorphosphan)wolfram
$W(PCl_3)_6$ = Hexakis(trichlorphosphan)wolfram
Komplexe des Typs $W(PF_3)_5L$
mit L = $N_2$, Aceton und andere Ketone bzw. Aldehyde. CO, $C_2(C_6H_5)_2$, $CH_3CN$, $ET_2O$, THF
Komplexe des Typs $W(PF_3)_4(\eta^4\text{-}L)$
mit L = 1,5,-Cyclooctadien, Norbornadien und andere Diene
Komplexe des Typs $W(PF_3)_3(\eta^6\text{-}L)$
mit L = Aren (Benzol, Toluol, Mesitylen etc.)
oder L = Trien (Cycloheptatrien etc.)

Durch die Verwendung dieser neuartigen Klassen von Wolfram-Komplexverbindungen, welche an und für sich aus einem Bericht von T. Kruck aus "Angewandte Chemie", 79 (1967) Seiten 28 bis 43, bekannt sind, gelingt es, durch gezielte Zersetzung dieser Substanzen (thermisch, plasmaangeregt, laserinduziert), Wolfram konform bei relativ niedrigen Temperaturen abzuscheiden. Da für die Wolframabscheidung nur die Zersetzung einer Substanz notwendig ist, deren Zersetzungsprodukte alle flüchtig sind, läßt sich Wolfram mit diesen Substanzen mit hoher Abscheiderate und besserer Kantenbedeckung abscheiden als bei der Wolframabscheidung mit Wolframhexafluorid und Wasserstoff.

Die gegenüber dem in der DE-OS 1 900 919 erreichte bessere Homogenität in der Schichtdicke wird dadurch erzielt, daß Konzentrationsschwankungen in der Gasphase bei dem pyrolythischen Prozeß keine Rolle mehr spielen und der verbleibende Einfluß der Substrattemperatur durch eine geeignete Heizvorrichtung auf ein Minimum reduziert werden kann.

Die Verdampfung der festen Substanzen erfolgt bei Temperaturen unter 200° C, wobei zum Transport Wasserstoff oder ein Edelgas, wie zum Beispiel Argon oder Helium vorteilhaft eingesetzt werden. Die Zersetzung selbst findet bei Temperaturen unter 450° C statt.

Findet die Zersetzung bei vermindertem Druck p statt (LPCVD = low pressure chemical vapor deposition), zum Beispiel bei einem p im Bereich von $10^{-3}$ mbar bis 100 mbar, so können höhere Abscheideraten bei gleichzeitiger Verbesserung der Schichtdickenhomogenität erreicht werden.

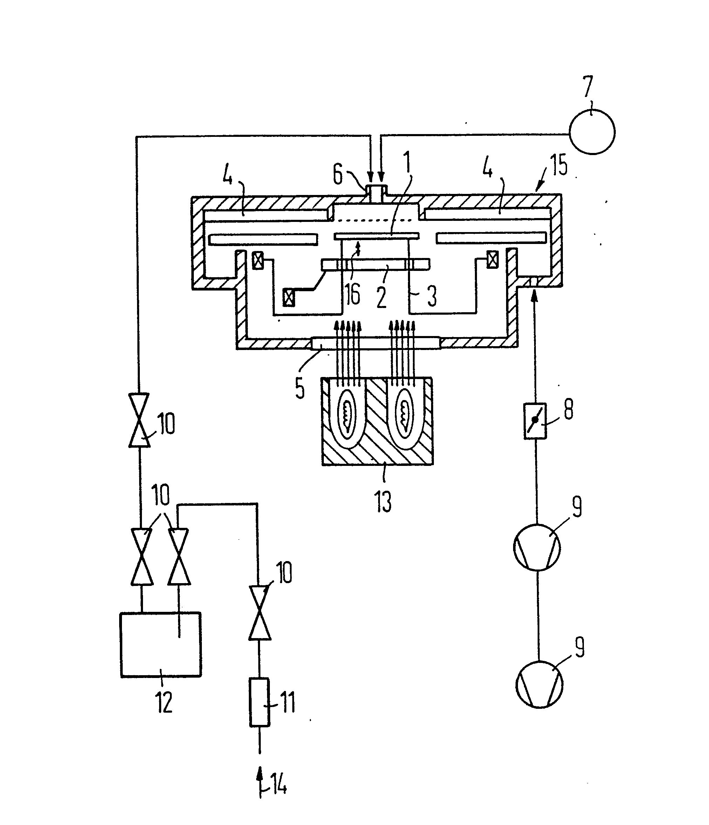

Findet die Zersetzung in einem Plasma-CVD-Reaktor (wie in der Figur dargestellt) statt, kann die Abscheidetemperatur auf zum Beispiel 350° C gesenkt werden bei gleichzeitiger Erhöhung der Abscheiderate, ohne die Gleichmäßigkeit der abgeschiedenen Wolframschichten zu vermindern.

Die Figur zeigt in schematischer Darstellung eine Plasma-CVD-Anlage, wie sie zur Durchführung des erfindungsgemäßen Verfahrens benutzt werden kann. In der Reaktorkammer 15 ist eine zu beschichtende Halbleitersubstratscheibe 1 auf einem Halbleitersubstratscheibenlift 3 zwischen dem Gaseinlaßbereich 6 und dem Suszeptor 2 angeordnet. Die Bewegung des Halbleiterscheibenlifts ist mit dem Doppelpfeil 16 angedeutet. Zur Evakuierung der Reaktorkammer 15 sind zwei Vakuumpumpen 9 vorgesehen, die über ein Butterflyventil 8 angeschlossen sind. Zur Erzeugung des Plasma wird ein RF-Generator 7 eingesetzt, wobei einzelne Bereiche der Reaktorkammer 15 durch Isolatoren 4 abgeschirmt sind. Die flüchtigen Wolfram-Ausgangsverbindungen werden in einem Verdampfergefäß (Sublimator) 12 bereitgestellt, in das als Trägergas 14 eingesetztes Helium oder Argon zugeführt wird. Alle Gaszuleitungen sind mit Durchflußmengenreglern (massflowcontroller) 11 und Pneumatikventilen 10 versehen. Zur Einstellung der Abscheidetemperatur in der Reaktorkammer 15 sind Lampen bzw. ein Reflektormodul 13 vorgesehen, welches die in der Reaktorkammer 15 befindliche Anordnung durch ein Quarzfenster 5 bestrahlt.

Findet die Zersetzung durch gezielte Anregung der W-PF₃-Bindung, zum Beispiel durch laserinduzierte CVD statt, lassen sich hochreine Wolframschichten abscheiden, die in ihren geometrischen Abmessungen nur durch die Breite des Laserstrahls begrenzt werden. So kann beispielsweise eine Kontaktlochauffüllung gleichzeitig mit dem "Schreiben" einer Leitbahn (interconnect) über das Kontaktloch erfolgen.

Für die thermische Zersetzung der Wolframkomplexverbindungen und die Abscheidung aus der Gasphase kann beispielsweise eine LPCVD-Reaktoranordnung verwendet werden wie sie in der bereits erwähnten europäischen Patentanmeldung 0 090 319 beschrieben ist.

Im Vergleich zu der schon lange bekannten Verwendung der Verbindung Wolframhexacarbonyl ($W(CO)_6$) haben die erfindungsgemäßen Substanzen den Vorteil, daß die Zersetzungsprodukte - in der Hauptsache $PF_3$ oder $PCl_3$ - keine festen Verbindungen bei der Zersetzungstemperatur mit Wolfram bilden. Dagegen kann es bei der Zersetzung von Wolframhexacarbonyl zum Einbau von Wolframcarbid oder Wolframoxid in die Wolframschicht kommen.

Ein Beispiel für einen Reaktionsablauf nach der Lehre der Erfindung:

$$W(PF_3)_5N_2 \text{ (fest)} \xrightarrow{80°C} W(PF_3)_5N_2 \text{ (gasförmig)} \xrightarrow{300°C} W + 5\,PF_3 + N_2$$

Die Abscheiderate kann unter optimierten Bedingungen über 300 nm/min betragen.

## Ansprüche

1. Verfahren zum konformen Abscheiden von Wolfram auf Halbleitersubstrate, insbesondere beim Auffüllen von in Isolationsschichten geätzten Kontaktlöchern, wie es zur Herstellung von höchstintegrierten Halbleiterschaltungen zur Ausbildung von elektrischen Leitbahnen auf mit Halbleiterstrukturen versehenen Substraten erforderlich ist, durch Zersetzung aus der Gasphase unter Verwendung von Wolframhalogenphosphanverbindungen, **dadurch gekennzeichnet,** daß als Ausgangsverbindungen für die Zersetzung feste, flüchtige Trihalogenphosphan-Wolframkomplexverbindungen verwendet werden, und daß die Zersetzung thermisch bei Temperaturen unter 450°C, durch Plasmaaktivierung oder laserinduziert durchgeführt wird.

2. Verfahren nach Anspruch 1, **dadurch gekennzeichnet,** daß Wolfram-Komplexverbindungen wie Hexakis(trifluorphosphan)wolfram ($W(PF_3)_6$) oder Hexakis(trichlorphosphan)wolfram ($W(PCl_3)_6$) verwendet werden.

3. Verfahren nach Anspruch 1, **dadurch gekennzeichnet,** daß Komplexe des Typs $W(PF_3)_5 L$ mit $L = N_2$, Aceton und andere Ketone bzw. Aldehyde, CO, $C_2(C_6H_5)_2$, $CH_3CN$, Diethylether ($Et_2O$) und Tetrahydrofuran (THF) verwendet werden.

4. Verfahren nach Anspruch 1, **dadurch gekennzeichnet,** daß Komplexe des Typs $W(PF_3)_4 - (\eta^4-L)$ mit L = 1.5 Cyclooctadien, Norbornadien und andere Diene verwendet werden.

5. Verfahren nach Anspruch 1, **dadurch gekennzeichnet,** daß Komplexe des Typs $W(PF_3)_3 - (\eta^6-L)$ mit L = Aren wie Benzol, Toluol, Mesitylen oder L = Trien wie Cycloheptatrien verwendet werden.

6. Verfahren nach einem der Ansprüche 1 bis 5, **dadurch gekennzeichnet,** daß die Reaktionsgase bei vermindertem Druck zersetzt werden.

7. Verfahren nach einem der Ansprüche 1 bis 6, **dadurch gekennzeichnet,** daß in einem Druckbereich von $10^{-3}$ mbar bis 100 mbar bei der thermischen Zersetzung, in einem Druckbereich von 1 mbar bis 10 mbar bei der plasmainduzierten Zersetzung und in einem Druckbereich von $10^{-3}$ mbar bis 1 bar bei der laserinduzierten Zersetzung gearbeitet wird.

8. Verfahren nach einem der Ansprüche 1 bis 7, **dadurch gekennzeichnet,** daß als Trägergas für die Wolframkomplexverbindung Wasserstoff und/oder Edelgase wie Argon oder Helium verwendet werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | DE-A-1 900 119 (SIEMENS) <br> * Insgesamt * | 1 | H 01 L 21/285 |
| A,D | | 2-8 | |
| | --- | | |
| Y | SOLID STATE TECHNOLOGY, Band 27, Nr. 3, März 1983, Seiten 125-128; C.C. TANG et al.: "Plasma-enhanced deposition of tungsten, molybdenum, and tungsten silicide films" <br> * Seite 125, Spalte 1, Zeilen 32-46 * | 1 | |
| | --- | | |
| A | US-A-4 568 565 (GUPTA et al.) <br> * Spalte 3, Zeilen 38-63 * | Y | |
| | ----- | | |

| RECHERCHIERTE SACHGEBIETE (Int. Cl.4) |
|---|
| H 01 L |

Der vorliegende Recherchenbericht wurde für alle Patentansprüche erstellt

| Recherchenort | Abschlußdatum der Recherche | Prüfer |
|---|---|---|
| DEN HAAG | 27-06-1989 | PHEASANT N.J. |